# EUROPEAN PATENT APPLICATION

(11) **EP 2 615 196 A1**
(43) Date of publication of application: **17.07.2013**
(21) Application number: 11830736.2
(22) Date of filing: 06.10.2011
(51) Int. Cl.: C25D 1/04, C25D 7/06, H05K 1/09

(54) **COPPER FOIL AND MANUFACTURING METHOD THEREFOR, COPPER FOIL WITH CARRIER AND MANUFACTURING METHOD THEREFOR, PRINTED CIRCUIT BOARD, AND MULTILAYER PRINTED CIRCUIT BOARD**

(30) Priority: 06.10.2010 JP 2010226453
(71) Applicant: Furukawa Electric Co., Ltd., Chiyoda-ku Tokyo 100-8322 (JP)
(72) Inventor: KAWAKAMI, Akira, Tokyo 100-8322 (JP)
(74) Representative: Horn Kleimann Waitzhofer
(86) International application number: PCT/JP2011/073097
(87) International publication number: WO 2012/046804

(57) **Abstract**

Provided is a copper foil with a carrier capable of realizing wiring at line/space = 15 µm/15 µm or less on a printed circuit board on which the copper foil is laminated. Further provided is a printed circuit board or a multilayer printed circuit board capable of realizing fine-pattern wiring at line/space = 15 µm/15 µm or less using the copper foil. The copper foil is obtained by forming a release layer and a copper foil in this order on a carrier foil having a surface on which a mean spacing Sm as defined in JIS-B-06012-1994 between irregularities of ridges is 25 µm or more, and peeling off the copper foil from the carrier foil. The copper foil with a carrier is obtained by forming a release layer and a copper foil in this order on a carrier foil that is said copper foil, wherein a spacing between irregularities of ridges on a surface of the carrier foil on which the copper foil is formed is 25 µm or more in a mean spacing Sm as defined in JIS-B-06012-1994. A roughening treatment layer as necessary and a surface treatment layer are formed in this order on a surface of the copper foil.

## Description

### Technical Field

The present invention relates to a copper foil or a copper foil with a carrier, and particularly relates to a copper foil or a copper foil with a carrier that is preferable for use in the manufacture of a printed circuit board or a multilayer printed circuit board with high-density and fine wiring, and a method for manufacturing the same.
Furthermore, the present invention relates to a printed circuit board or a multilayer printed circuit board using the copper foil or the copper foil with a carrier.

### Background Art

As a copper foil used for high-density and fine wiring (fine patterning), a copper foil with a thickness of 1 to 9 µm, particularly preferably 1 to 5 µm is used.
A thin copper foil used for such fine patterning is offered on the market mainly as a copper foil with a carrier. Such a copper foil with a carrier uses an electrolytic copper foil as a carrier foil, and is manufactured by providing a release layer with a thickness of 1 µm or less on the carrier foil and forming a copper foil on the release layer. Since this sort of manufacturing method is used, if the thickness of a deposited copper foil is approximately 5 µm, the copper foil adopts (copies) the surface shape of the carrier foil as it is, and, thus, the obtained copper foil has a considerably rough matte surface.

For example, if a carrier foil (electrolytic copper foil) with a surface roughness Rz of approximately 2 µm is plated with copper to a thickness of 5 µm, a surface roughness Rz of the copper plating layer (copper foil) becomes approximately 2 to 4 µm. Furthermore, if the surface of this copper foil is subjected to roughening treatment for increasing the adhesiveness with a resin substrate, the surface roughness Rz further increases. Due to such a rough matte surface, the copper foil cannot be used as a copper foil for fine patterning that requires a high quality

In order to solve this problem, a copper foil has been proposed that uses a copper foil with a surface roughness Rz of 1.5 µm or less as a carrier foil, and that is manufactured by forming a release layer and an electrolytic copper plating layer in this order on the surface of the carrier foil and further forming a roughened face on an outermost surface of the electrolytic copper plating layer (see Patent Document 1).
Furthermore, a technique has been also proposed that performs smoothing treatment (mechanical polishing, chemical polishing, electro-chemical polishing, etc.) on a surface of a carrier copper foil to reduce a surface roughness Rz to 2.0 µm or less (see Patent Document 2).

However, even if an electrolytic copper foil with a surface roughness Rz of 1.5 µm or less is used as the carrier foil, the obtained thin copper foil may have a surface roughness Rz of approximately 3.5 µm. On a printed circuit board using a copper foil with a surface roughness Rz of approximately 3.5 µm, approximately line/space = 30 µm/30 µm to 25 µm/25 µm is the limit in cutting the copper foil into fine wiring lines, and it is almost impossible to cut the copper foil into fine wiring lines at line/space = 15 µm/15 µm or less.
In this manner, if prescription is made only for the surface roughness Rz of the carrier foil, the copper foil deposited thereon may not always have a smooth surface, and, thus, the obtained copper foil may not be satisfactory as a copper foil for forming fine patterning on a printed circuit board.

### Citation List

### Patent Document

[Patent Document 1] JP 2000-269637A
[Patent Document 2] JP 2005-076091A

### Summary of Invention

### Technical Problem

As a result of a study on this problem, the inventor found that, in electrodeposition of copper on a surface of a carrier foil, the copper is deposited in a concentrated manner on peaks of ridges on the surface of the carrier foil, the deposition rate of the copper differs between the peaks and the valleys, and, thus, the surface of the finally obtained copper foil becomes rough.
As a result of an in-depth study on a surface of a carrier foil and a deposition process of copper based on this finding, the inventor found that, if a spacing between the irregularities of the ridges on the surface of the carrier foil is properly set, the copper foil deposited on the surface of the carrier foil gains a smooth surface (matte surface), and, thus, the present invention was achieved.

It is an object of the present invention to provide a copper foil or a copper foil with a carrier capable of realizing wiring at line/space = 15 µm/15 µm or less on a printed circuit board on which the copper foil is laminated.
It is anther object of the present invention to provide a printed circuit board or a multilayer printed circuit board capable of realizing fine-pattern wiring at line/space = 15 µm/15 µm or less using the copper foil.

### Solution to Problem

The present invention is directed to a copper foil obtained by forming a release layer and a copper foil in this order on a carrier foil having a surface on which a mean spacing Sm as defined in JIS-B-06012-1994 between irregularities of ridges is 25 µm or more, and peeling off the copper foil from the carrier foil.
Furthermore, the present invention is directed to a method for manufacturing a copper foil, including the steps of: forming a release layer and a copper foil in this order on the carrier foil; and peeling off the copper foil from the carrier foil.

The present invention is directed to a copper foil obtained by forming a release layer, a copper foil, a roughening treatment layer, and a surface treatment layer in this order on a carrier foil having a surface on which a mean spacing Sm as defined in JIS-B-06012-1994 between irregularities of ridges is 25 µm or more, and peeling off the copper foil provided with the roughening treatment layer and the surface treatment layer from the carrier foil.
Furthermore, the present invention is directed to a method for manufacturing a copper foil, including the steps of: forming a release layer, a copper foil, a roughening treatment layer, and a surface treatment layer in this order on the carrier foil; and peeling off the copper foil provided with the roughening treatment layer and the surface treatment layer from the carrier foil.

The present invention is directed to a copper foil obtained by forming a release layer, a copper foil, a roughening treatment layer, and a surface treatment layer in this order on a carrier foil that is made of an electrolytic copper foil having a surface on which a mean spacing Sm as defined in JIS-B-06012-1994 between irregularities of ridges is 25 µm or more, and peeling off the copper foil provided with the roughening treatment layer and the surface treatment layer from the carrier foil.
Furthermore, the present invention is directed to a method for manufacturing a copper foil, including the steps of: forming a release layer, a copper foil, a roughening treatment layer, and a surface treatment layer in this order on the carrier foil; and peeling off the copper foil provided with the roughening treatment layer and the surface treatment layer from the carrier foil.

The present invention is directed to a copper foil with a carrier obtained by forming a release layer and a copper foil in this order on a carrier foil, wherein a spacing between irregularities of ridges on a surface of the carrier foil on which the copper foil is formed is 25 µm or more in a mean spacing Sm as defined in JIS-B-06012-1994.
Furthermore, the present invention is directed to a method for manufacturing a copper foil with a carrier, including the step of forming a release layer and a copper foil in this order on the carrier foil.

The present invention is directed to a copper foil with a carrier obtained by forming a release layer, a copper foil, a roughening treatment layer as necessary, and a surface treatment layer in this order on a carrier foil having a treatment face with a surface roughness Rz of 1.5 µm or less, wherein a spacing between irregularities of ridges on a surface of the carrier foil on which the copper foil is formed is 25 µm or more in a mean spacing Sm as defined in JIS-B-06012-1994.
Furthermore, the present invention is directed to a method for manufacturing a copper foil with a carrier, including the step of forming a release layer, a copper foil, a roughening treatment layer as necessary, and a surface treatment layer in this order on the carrier foil.

The present invention is directed to a copper foil with a carrier obtained by forming a release layer, a copper foil, a roughening treatment layer as necessary, and a surface treatment layer in this order on a carrier foil having a treatment face with a surface roughness Rz of 1.5 µm or less, wherein a spacing between irregularities of ridges on a surface of the carrier foil on which the copper foil is formed is 25 µm or more in a mean spacing Sm as defined in JIS-B-06012-1994, the carrier foil being an electrolytic copper foil.
Furthermore, the present invention is directed to a method for manufacturing a copper foil with a carrier, including the step of forming a release layer, a copper foil, a roughening treatment layer as necessary, and a surface treatment layer in this order on the carrier foil.

It is preferable that a roughened face on which a dispersion (3σ) in a surface roughness Rz is 0.65 or less is provided.
It is preferable that the release layer is a layer made of Cr, Ni, Co, Fe, Mo, Ti, W, or P, and/or an alloy thereof or a hydrous oxide thereof, or an organic coating.

It is desirable that the roughening treatment layer is a layer formed by roughening treatment through electrodeposition of fine copper particles on the surface of the copper foil.

The present invention is directed to a printed circuit board obtained by laminating a resin substrate on a surface of the copper foil or the copper foil with a carrier.

The present invention is directed to a multilayer printed circuit board obtained by forming a wiring circuit as necessary on the printed circuit board, and stacking a plurality of said printed circuit boards.

Note that, in the present invention, the mean spacing Sm between irregularities of ridges refers to a mean spacing (µm) between irregularities of a roughness profile within a sampling length as defined in JIS-B-06012-1994.
Furthermore, the surface roughness Rz refers to an Rz value as defined in JIS-B-0601.

### Advantageous Effects of Invention

The present invention can provide a thin copper foil capable of realizing wiring at line/space = 15 µm/15 µm or less on a circuit board, by using, as a carrier foil, an electrolytic copper foil on which a mean spacing Sm between irregularities of ridges is 25 µm or more. The present invention can further provide a printed circuit board capable of realizing high-density and fine wiring, by laminating the copper foil on a resin substrate.
Furthermore, it is possible to provide a multilayer printed circuit board capable of realizing high-density wiring, by stacking a plurality of said printed circuit boards capable of realizing high-density and fine wiring using the copper foil or the copper foil with a carrier of the present invention.
Furthermore, it is possible to provide a copper foil having excellent high frequency properties, because the waviness of a carrier copper foil with a high Sm value is extremely low, and, thus, the waviness of a thin copper foil formed on this carrier copper foil can be made extremely low.

### Brief Description of Drawings

FIG. 1 shows a flowchart illustrating a method for manufacturing a copper foil.
FIG. 2 shows cross-sectional views of a manufactured copper foil.

### Description of Embodiments

According to an embodiment of the present invention, a carrier foil is made of an electrolytic copper foil on which a mean spacing Sm between irregularities of ridges is 25 µm or more. It is preferable that the carrier foil has a surface roughness Rz of 1.5 µm or less.
The reason for setting the Sm value at 25 µm or more is that, if the Sm value of a carrier foil is 25 µm or less, in electrodeposition of copper on a surface of the carrier foil, the copper is deposited in a concentrated manner on peaks of ridges on the surface of the carrier foil, the deposition rate of the copper differs between the peaks and the valleys, the surface of the finally obtained copper foil becomes rough, and, thus, when performing wiring at line/space = 15 µm/15 µm or less on a printed circuit board using the copper foil, problems occur such as sufficient linearity not being achieved.
If the Sm value on a surface of a carrier foil is set at 25 µm or more, a copper foil deposited on the carrier foil grows with a deposition rate not differing between the peaks and the valleys, and a copper foil having a surface that is extremely smooth and that is not wavy can be manufactured. In this case, it is possible to manufacture a printed circuit board on which the linearity of wiring lines is good even with high-density and fine wiring at line/space = 15 µm/15 µm or less.

Furthermore, if the mean spacing Sm value of a carrier foil is set at 50 µm or more, it is possible to manufacture a printed circuit board on which the linearity of wiring lines is good even with high-density and fine wiring at line/space = 10 µm/10 µm or less. If such printed circuit boards are stacked, a multilayer printed circuit board can be manufactured.
Furthermore, if a carrier foil with an Sm value of 25 µm or more is used, a release layer with a uniform thickness can be formed on the smooth carrier foil, and, thus, the carrier peel strength when peeling off the copper foil from the carrier foil becomes stable.

The copper foil and the copper foil with a carrier according to the embodiment of the present invention can be offered on the market as a copper foil in the case where the thickness of the copper foil deposited via the release layer on the carrier foil allows the copper foil to keep its product form even after being peeled off from the carrier foil, or as a copper foil with a carrier in the case where the thickness makes it difficult for the copper foil to be peeled off.

A carrier foil that is made of an electrolytic copper foil on which a mean spacing Sm value is 25 µm or more is manufactured as follows. First, the surface of a titanium drum is polished to achieve a uniform surface roughness. Then, the drum is plated with copper to a desired thickness using a copper plating solution that forms a smooth and specular-gloss surface, and only a copper foil with an Sm value of 25 µm or more after the foil formation is selected as a carrier copper foil. Note that copper foils having various Sm values can be formed depending on the bath composition of the plating solution, the current density, and the plating time.
As the copper plating solution that forms a smooth and specular-gloss surface, a copper plating solution disclosed in Japanese Patent No. 3,313,277, or commercially available plating solutions containing gloss plating additives for ornamental purposes can be used.
According to the embodiment of the present invention, when manufacturing a continuous carrier foil, the bath composition of the plating solution, the current density, and the plating time are set as invariant parameters, and the titanium drum is polished, each time during set up change, or while the drum is rotating during foil formation, such that the carrier foil has an Sm value of 25 µm or more. Furthermore, adjustment is performed such that the matte surface of the carrier foil has an Sm value of 25 µm or more, by automatically refilling a gloss agent while measuring use state such that the matte surface on the drum is kept smooth.

The release layer formed on the matte surface of the carrier foil is desirably a layer made of Cr, Ni, Co, Fe, Mo, Ti, W, or P, and/or an alloy thereof or a hydrous oxide thereof, or an organic coating. These metals (including alloys) and hydrous oxides thereof forming the release layer are preferably formed on the carrier foil by cathode electrolysis. Note that, in order to stably perform the peeling off operation after hot-pressing the copper foil with a carrier on an insulating substrate, nickel, iron, an iron-nickel alloy, or an alloy layer thereof may be preferably provided as the base of the release layer.
Preferable examples of materials for forming the release layer include chromium alloys that are binary alloys such as nickel-chromium, cobalt-chromium, iron-chromium, chromium-molybdenum, chromium-titanium, chromium-tungsten, and chromium-phosphorus, nickel-cobalt, nickel-iron, nickel-molybdenum, nickel-titanium, nickel-tungsten, nickel-phosphorus, iron-cobalt, cobalt-molybdenum, cobalt-titanium, cobalt-tungsten, cobalt-phosphorus, iron-molybdenum, iron-titanium, iron-tungsten, iron-phosphorus, titanium-molybdenum, molybdenum-tungsten, molybdenum-phosphorus, titanium-tungsten, titanium-phosphorus, and tungsten-phosphorus.

Furthermore, preferable examples thereof include ternary alloys such as nickel-chromium-cobalt, nickel-chromium-iron, nickel-chromium-molybdenum, nickel-chromium-titanium, nickel-chromium-tungsten, nickel-chromium-phosphorus, cobalt-chromium-iron, cobalt-chromium-molybdenum, cobalt-chromium-tungsten, cobalt-chromium-titanium, cobalt-chromium-phosphorus, nickel-cobalt-molybdenum, nickel-iron-molybdenum, nickel-titanium-molybdenum, nickel-molybdenum-tungsten, nickel-phosphorus-molybdenum, nickel-cobalt-molybdenum, nickel-cobalt-iron, nickel-cobalt-titanium, nickel-cobalt-tungsten, nickel-cobalt-phosphorus, nickel-molybdenum-iron, nickel-molybdenum-titanium, nickel-molybdenum-tungsten, nickel-molybdenum-phosphorus, chromium-iron-molybdenum, chromium-molybdenum-titanium, chromium-molybdenum-tungsten, chromium-molybdenum-phosphorus, iron-chromium-titanium, iron-chromium-tungsten, iron-chromium-phosphorus, iron-nickel-titanium, iron-nickel-tungsten, iron-nickel-phosphorus, iron-cobalt-titanium, iron-cobalt-tungsten, and iron-cobalt-phosphorus.

Furthermore, an organic coating used for forming the release layer is preferably one, or two or more selected from nitrogen-containing organic compound (1-hydroxybenzotriazole, 1-hydroxybenzotriazole N hydrate, benzotriazole, 5-methyl-1-hydroxybenzotriazole, 6-methyl-1-hydroxybenzotriazole, 6-ethyl-1-hydroxybenzotriazole, carboxybenzotriazole, 3-amino-1,2,4-triazole, etc.), sulfur-containing organic compound (4-(1-naphthol)benzotrithiole, etc.) and carboxylic acid (oxalic acid, malonic acid, succinic acid, etc.).

### Manufacturing Method

A thin copper foil is formed on the release layer by cathode electrolysis. In order to form a thin copper foil having a matte surface on which a mean spacing Sm is 26 µm or more or a surface roughness Rz of 3.5 µm or less, the matte surface of the carrier foil is adjusted so as to have a mean spacing Sm of 25 µm or more or a Rz of 1.5 µm or less, and, furthermore, the surface of a power supply roll is subjected to surface treatment that reduces electrical resistance in order to provide uniform current density across a width of 500 mm of the carrier foil for the formation of the release layer or the thin copper foil. For example, the surface of the power supply roll is plated with silver. Alternatively, adjustment is performed such as increasing the number of electric contact points in the width direction of the power supply roll, so that not only smooth but also uniform surface state can be provided in which the surface state in the width direction is not uneven (e.g., tape adhesive residue: 10 spots or less) in a tape cross-cut test. Moreover, since the carrier foil has a smooth and uniform matte surface across a width of 500 mm, the carrier foil can exhibit stable peel strength.
Furthermore, depending on a resin substrate used, the adhesion may be insufficient at the time of lamination only with surface treatment (anti-rust treatment, coupling treatment) on the thin copper foil. In that case, in order to increase the adhesive strength between the resin substrate and the thin copper foil, a roughening treatment layer is provided on the surface of the copper foil as necessary If roughening treatment is performed, a uniformly roughened face is obtained by providing a uniform current density as described above. In a similar manner, in the tape cross-cut test, the copper particle adhesion on a tape is observed at, for example, 10 spots or less. Accordingly, a uniformly roughened state can be provided, the adhesion is improved, and the etching linearity is good.

### Examples

### Next, examples of the present invention will be described in detail.

Note that the following examples are given for the purpose of providing a general description of the present invention, and are not intended to limit the present invention.

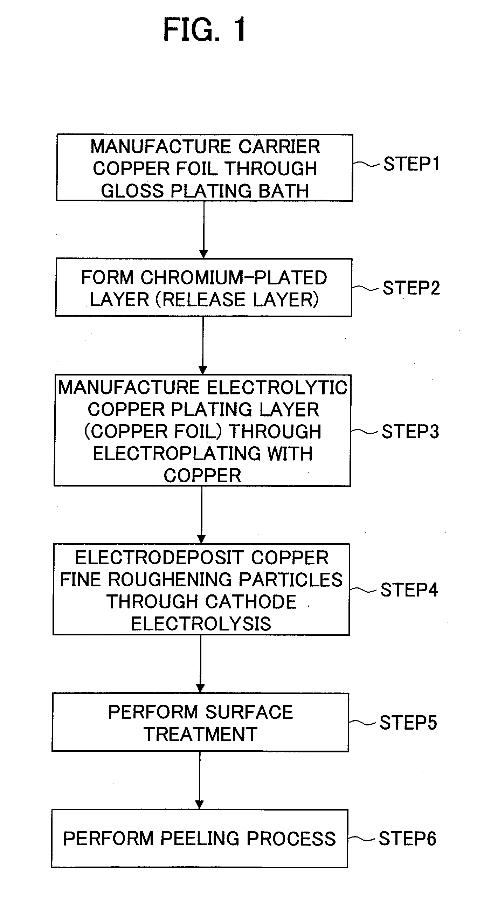

### (1) Manufacture of the carrier copper foil; Step 1 in FIG. 1

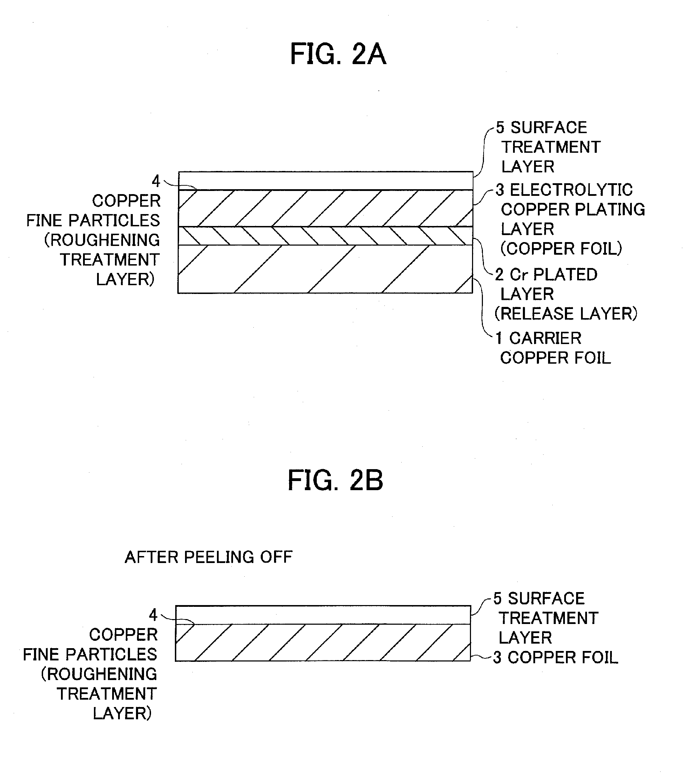

With a gloss plating bath having the composition below, an electrolytic copper foil 1 with a width of 500 mm and a thickness of 35 µm was manufactured as shown in FIG. 2. An apparatus for manufacturing an electrolytic copper foil included a cathode in the shape of a rotating titanium drum whose surface roughness was adjusted through polishing with #3000 buff, and an anode (lead or noble metal oxide-coated titanium electrode) disposed in concentric with the cathode. While a gloss plating bath (solution) was flowing through the apparatus, a current was caused to flow between the electrodes, and, thus, copper was deposited to a predetermined thickness on a surface of the cathode. Then, the copper was separated from the surface of the cathode, and, thus, a carrier copper foil was manufactured.
In the examples, the carrier foil had a thickness of 35 µm, but the thickness may be 35 µm or more as necessary The upper limit of the thickness is set at 200 µm or less from an economical point of view.

The manufacture conditions of examples and comparative examples are listed below.

### [Examples 1 to 8]

### Plating solution

| -Bath composition: | | |
|---|---|---|
| | Metallic copper | 60 g/l |
| | Sulfuric acid | 100 g/l |
| | Chloride ion | 30 ppm (as NaCl) |
| | Hydroxyethylcellulose | 5 ppm |
| -Bath temperature | | 58°C |
| -Current density | | 5 to 50 A/dm² |

Carrier copper foils (35 µm) (Examples 1 to 8) with various mean spacing Sm values were manufactured on a polished titanium drum using the plating solution having the above-listed plating bath composition while changing the current density and the time.
The mean spacing Sm values of the matte surfaces (portions that were in contact with the plating solution) of the electrolytic copper foils in Examples 1 to 8 were measured. Table 1 shows the measured values.

### [Comparative Examples 1 and 2]

### Plating solution

| -Bath composition: | | |
|---|---|---|
| | Metallic copper | 60 g/l |
| | Sulfuric acid | 100 g/l |
| -Bath temperature | | 50°C |
| -Current density | | 4 to 20 A/dm² |

Carrier copper foils (35 µm) (Comparative Examples 1 and 2) with various mean spacing Sm values were manufactured on a polished titanium drum using the plating solution having the above-listed plating bath composition while changing the current density and the time. The Sm values of the matte surfaces of the electrolytic copper foils in Comparative Examples 1 and 2 were measured. Table 1 shows the measured values.

### (2) Formation of the release layer; Step 2 in FIG. 1

Next, the matte surface of the obtained carrier copper foils or the soldering side shown in Comparative Example 3 was electroplated with chromium in a successive manner, and, thus, a chromium-plated layer (release layer) 2 with a thickness of 0.05 µm was formed as shown in FIG. 2.

### (3) Manufacture of the thin copper foil; Step 3 in FIG. 1

The chromium-plated layer obtained in Examples 1, 4, and 8 and Comparative Examples 1 and 3 was electroplated with copper under the following conditions. Thus, an electrolytic copper plating layer (copper foil) 3 with a thickness of 5 µm and a surface roughness Rz of 3.5 µm or less was manufactured as shown in FIG. 2, and the samples of Examples 9, 10, and 11 and Comparative Examples 4 and 5 were formed.

### Plating solution

| -Bath composition: | | |
|---|---|---|
| | Metallic copper | 60 g/l |
| | Sulfuric acid | 100 g/l |
| | Chloride ion | 30 ppm (as NaCl) |
| | Hydroxyethylcellulose | 5 ppm |
| -Bath temperature | | 58°C |
| -Current density | | 5 to 50 A/dm² |

Although the thickness of the thin copper foil can be changed within a range of 1 µm to 12 µm by adjusting the plating time, the thickness of all copper foils in Examples 1 to 8 was set at 5 µm. As necessary, the thickness of the copper foil can be increased to that of the carrier foil.

### Dispersion in the roughened face Rz

A dispersion 3σ in the surface roughness Rz of the roughened faces in Examples 10 to 12 and Comparative Examples 4 and 5 was obtained. The dispersion was 0.6 or less in Examples 10 to 12. That is to say, the dispersion in Rz of the roughened faces after the roughening treatment was small, and copper foils with a carrier foil having uniform surfaces were obtained.

### (4) Electrodeposition of fine roughening particles; Step 4 in FIG. 1

The thin copper foils (electrolytic copper plating layers) obtained in Examples 1 and 2 were subjected as necessary to cathode electrolysis with a direct current under the following conditions, and, thus, copper fine roughening particles (4 in FIG. 2) were electrodeposited.

### (4-1) Formation of fine particle core

| | | |
|---|---|---|
| (a) Electrolyte composition; | | |
| | Copper sulfate (CuSO₄·5H₂O) | 100 g/l |
| | Sulfuric acid (H₂SO₄) | 120 g/l |
| | Sodium molybdate (Na₂MO₄·2H₂O) | 0.6 g/l |
| | Ferrous sulfate (FeSO₄·7H₂O) | 15 g/l |
| (b) Electrolyte temperature | | 35°C |
| (c) Current density | | 40 A/dm² |
| (d) Treatment time | | 3.5 seconds |

### (4-2) Capsule plating

| | | |
|---|---|---|
| (a) Electrolyte composition; | | |
| | Copper sulfate (CuSO₄·5H₂O) | 250 g/l |
| | Sulfuric acid (H₂SO₄) | 100 g/l |
| (b) Electrolyte temperature | | 50°C |
| (c) Current density | | 20 A/dm² |
| (d) Treatment time | | 7.0 seconds |

If the peel strength of the copper foil has to be further increased, the surface of the copper foil may be subjected to roughening treatment to a predetermined surface roughness.

### (5) Surface treatment; Step 5 in FIG. 1

The surface of the thin copper foil, or the surface of the thin copper foil formed on the thin copper foil subjected to the roughening treatment was subjected to surface treatment in order to improve the adhesive strength with resin and to prevent rust, and, thus, a surface treatment layer 5 was formed as shown in FIG. 2.
As the surface treatment, nickel-phosphorus plating (Ni = 0.1 mg/dm²) and zinc plating (Zn = 0.1 mg/dm²) were performed, and chromate treatment (Cr = 0.06 mg/dm²) was further performed thereon, after which treatment with an epoxy-based silane coupling agent (Si = 0.004 mg/dm²) was performed.

### Evaluation of the line linearity

Wiring lines on a printed circuit board were formed by etching. Since the etching is performed at line/space = 10 µm/10 µm and line/space = 15 µm/15 µm, if the copper foil does not have a uniform thickness, the etching speed may vary depending on the thickness, and, thus, the line linearity may be poor. Accordingly, the line linearity can be used to evaluate smoothness and uniformity in the thickness of the copper foil.

The copper foils with a carrier manufactured Examples 1 to 12 and Comparative Examples 1 to 5 were each laminated on a BT resin substrate under pressing conditions of 220°C x 90 min and 15 kgf/cm², and, thus, printed circuit boards were manufactured. Wiring lines at line/space = 10 µm/10 µm and line/space = 15 µm/15 µm were formed by etching. A cross-section of each fine wiring was measured by SEM observation to obtain a bottom width and a top width, and a difference between the widths was calculated. Fine wiring requires a difference between the bottom width and the top width to be small, and, thus, a difference of 15% or less was taken to be "OK". Note that the determination standards were set such that a difference of 5% or less was taken to be "Excellent", 5 to 10% was taken to be "Good", 10 to 15% was taken to be "Fair", and15% or more was taken to be "Poor". Table 1 lists the evaluation results.

### Cross-cut evaluation test (JIS K5400-8.5)

The copper foils with a carrier manufactured in Examples 1 to 9 and Comparative Examples 1 to 3 were each laminated on a BT resin substrate under pressing conditions of 220°C x 90 min and 15 kgf/cm², and, thus, printed circuit boards were manufactured. Then, 11 cut lines were formed through the thin copper foil from which the carrier copper foil had been peeled off, using a cutter knife with a dedicated guide having grooves at an interval of 1 mm.
Subsequently, the orientation was changed by 90°, and 11 more cut lines were formed, and, thus, samples each having a lattice pattern with 100 sections were formed.
Subsequently, a cellophane pressure-sensitive tape having an adhesive force of 2.94 N/10 mm (300 gf/10 mm) or more and a width of 18 mm or 24 mm was uniformly applied on a face of the sample thin copper foil across a length of 50 mm, and was rubbed with an eraser so as to completely adhere to the face of the sample thin copper foil. The same processing was repeated three times at an interval of 50 mm in the longitudinal direction of the face of the thin copper foil.
Lastly, 1 to 2 minutes after the tape had been attached, an end of the tape was held such that the tape was oriented at a right angle with respect to the face of the thin copper foil and was then instantaneously peeled off.
Furthermore, the evaluation method of the cross-cut test here was set as follows. Since the smoother the thin copper foil, the lower the adhesive strength of the thin copper foil with the resin, the evaluation was performed based on the number of sections of copper foil adhering to the tape among 100 sections when the tape was peeled off such that a number of 96 to 100 was taken to be "Excellent", 76 to 95 was taken to be "Good", 51 to 75 was taken to be "Fair", and 0 to 50 was taken to be "Poor".

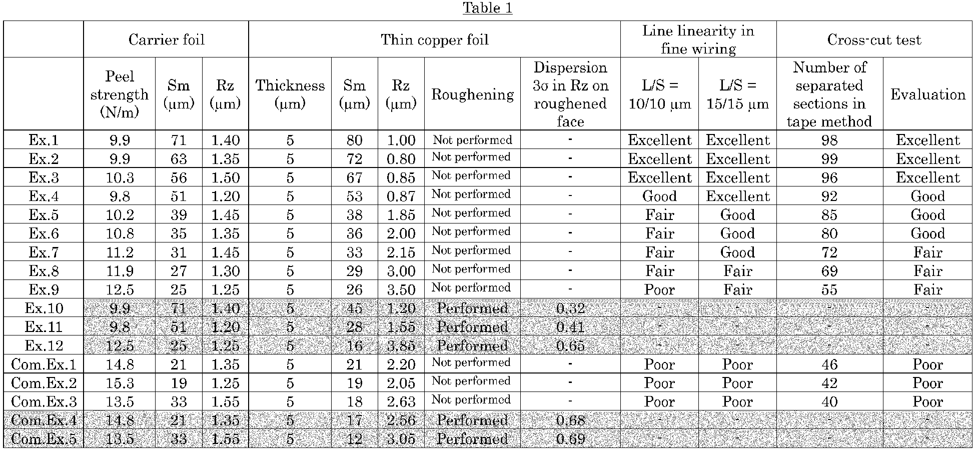

According to the copper foil with a carrier in the examples of the present invention, as clearly seen from Table 1, if the surface of the carrier copper foil has a mean spacing Sm value of 25 µm or more, a copper foil whose surface roughness is los and that is not wavy can be manufactured. Furthermore, if this copper foil is laminated on a resin substrate to form a printed circuit board, high-density and fine wiring at line/space = 15 µm/15 µm or less can be realized without impairing the line linearity Furthermore, at Sm values of 50 µm and 60 µm or more, the line linearity in high-density and fine wiring is further improved.

According to the examples of the present invention, if a carrier foil on which a mean spacing Sm value is 25 µm or more is used, a release layer with a uniform thickness can be formed on the smooth carrier foil, and, thus, the carrier peel strength when peeling off the copper foil from the carrier foil becomes stable. The waviness of a carrier copper foil with a high Sm value is extremely low, and, thus, the waviness of a copper foil formed on this carrier copper foil is made extremely low. Accordingly, a copper foil having excellent high frequency properties can be provided.

As described above, the present invention uses an electrolytic copper foil with an Sm value of 25 µm or more as carrier foil, and, thus, extremely narrow etching at line/space of 15 µm or less can be performed without impairing the linearity of wiring lines. Furthermore, a printed circuit board with high-density and fine wiring (ultra-fine patterning) and a multilayer printed circuit board with ultra-fine patterning can be provided.

### Industrial Applicability

The copper foils of the present invention can be used and applied as circuit conductors of various wiring devices, and the printed circuit boards of the present invention can be used and applied as various electronic devices and the like.

## Claims

1. A copper foil obtained by forming a release layer and a copper foil in this order on a carrier foil having a surface on which a mean spacing Sm as defined in JIS-B-06012-1994 between irregularities of ridges is 25 µm or more, and peeling off the copper foil from the carrier foil.

2. A copper foil including a copper foil and a surface treatment layer, obtained by forming a release layer, the copper foil, a roughening treatment layer, and the surface treatment layer in this order on a carrier foil having a surface on which a mean spacing Sm as defined in JIS-B-06012-1994 between irregularities of ridges is 25 µm or more, and peeling off the copper foil provided with the roughening treatment layer and the surface treatment layer from the carrier foil.

3. The copper foil according to claim 2, having a roughened face on which a dispersion (3σ) in a surface roughness is 0.65 or less.

4. A copper foil including a copper foil and a surface treatment layer, obtained by forming a release layer, the copper foil, a roughening treatment layer as necessary, and the surface treatment layer in this order on a carrier foil that is made of an electrolytic copper foil having a surface on which a mean spacing Sm as defined in JIS-B-06012-1994 between irregularities of ridges is 25 µm or more, and peeling off the copper foil from the carrier foil.

5. A method for manufacturing a copper foil, comprising the steps of:
forming a release layer and a copper foil in this order on a carrier foil having a surface on which a mean spacing Sm as defined in JIS-B-06012-1994 between irregularities of ridges is 25 µm or more; and
peeling off the copper foil from the carrier foil.

6. A method for manufacturing a copper foil, comprising the steps of:
forming a release layer, a copper foil, a roughening treatment layer, and a surface treatment layer in this order on a carrier foil having a surface on which a mean spacing Sm as defined in JIS-B-06012-1994 between irregularities of ridges is 25 µm or more; and
peeling off the copper foil provided with the roughening treatment layer and the surface treatment layer from the carrier foil.

7. A method for manufacturing a copper foil, comprising the steps of:
forming a release layer, a copper foil, a roughening treatment layer as necessary, and a surface treatment layer in this order on a carrier foil that is made of an electrolytic copper foil having a surface on which a mean spacing Sm as defined in JIS-B-06012-1994 between irregularities of ridges is 25 µm or more; and
peeling off the copper foil from the carrier foil.

8. A copper foil with a carrier obtained by forming a release layer and a copper foil in this order on a carrier foil having a treatment face with a surface roughness Rz of 1.5 µm or less,
wherein a spacing between irregularities of ridges on a surface of the carrier foil on which the copper foil is formed is 25 µm or more in a mean spacing Sm as defined in JIS-B-06012-1994.

9. A copper foil with a carrier obtained by forming a release layer, a copper foil, a roughening treatment layer, and a surface treatment layer in this order on a carrier foil having a treatment face with a surface roughness Rz of 1.5 µm or less,
wherein a spacing between irregularities of ridges on a treatment surface of the copper foil is 25 µm or more in a mean spacing Sm as defined in JIS-B-06012-1994.

10. The copper foil with a carrier according to claim 9, having a roughened face on which a dispersion (3σ) in a surface roughness is 0.65 or less.

11. A copper foil with a carrier obtained by forming a release layer, a copper foil, a roughening treatment layer as necessary, and a surface treatment layer in this order on a carrier foil that is made of an electrolytic copper foil having a treatment face with a surface roughness Rz of 1.5 µm or less,
wherein a spacing between irregularities of ridges on a treatment surface of the copper foil is 25 µm or more in a mean spacing Sm as defined in JIS-B-06012-1994.

12. A method for manufacturing a copper foil with a carrier, comprising the step of forming a release layer and a copper foil in this order on a carrier foil having a surface on which a mean spacing Sm as defined in JIS-B-06012-1994 between irregularities of ridges is 25 µm or more.

13. A method for manufacturing a copper foil with a carrier, comprising the step of forming a release layer, a copper foil, a roughening treatment layer, and a surface treatment layer in this order on a carrier foil having a surface on which a mean spacing Sm as defined in JIS-B-06012-1994 between irregularities of ridges is 25 µm or more.

14. A method for manufacturing a copper foil with a carrier, comprising the step of forming a release layer, a copper foil, a roughening treatment layer as necessary, and a surface treatment layer in this order on a carrier foil that is made of an electrolytic copper foil having a surface on which a mean spacing Sm as defined in JIS-B-06012-1994 between irregularities of ridges is 25 µm or more.

15. The copper foil according to any one of claims 1 to 4, wherein the release layer is a layer made of Cr, Ni, Co, Fe, Mo, Ti, W, or P, and/or an alloy thereof or a hydrous oxide thereof, or an organic coating.

16. The copper foil according to any one of claims 2 to 4, wherein the roughening treatment layer is a layer formed by roughening treatment through electrodeposition of fine copper particles on the surface of the copper foil.

17. The copper foil with a carrier according to any one of claims 8 to 11, wherein the release layer is a layer made of Cr, Ni, Co, Fe, Mo, Ti, W, or P, and/or an alloy thereof or a hydrous oxide thereof, or an organic coating.

18. The copper foil with a carrier according to claim 9 or 10, wherein the roughening treatment layer is a layer formed by roughening treatment through electrodeposition of fine copper particles on the surface of the copper foil.

19. A printed circuit board obtained by laminating a resin substrate on a surface of the copper foil according to any one of claims 1 to 4.

20. A printed circuit board obtained by laminating a resin substrate on a copper foil-side surface of the copper foil with a carrier according to any one of claims 8 to 11.

21. A multilayer printed circuit board obtained by forming a wiring circuit as necessary on the printed circuit board according to claim 19 or 20, and stacking a plurality of said printed circuit boards.
